# EUROPEAN PATENT APPLICATION

(11) **EP 4 390 632 A1**
(43) Date of publication of application: **26.06.2024**
(21) Application number: 22858152.6
(22) Date of filing: 15.06.2022
(51) Int. Cl.: G06F 3/02, H01H 13/705

(54) **ELECTRONIC DEVICE**

(30) Priority: 18.08.2021 JP 2021133405
(71) Applicant: Casio Computer Co., Ltd., Tokyo 151-8543 (JP)
(72) Inventor: KIMURA, Kanako, Hamura-shi, Tokyo 205-8555 (JP)
(74) Representative: Plougmann Vingtoft a/s
(86) International application number: PCT/JP2022/023978
(87) International publication number: WO 2023/021828

(57) **Abstract**

According to an embodiment, an electronic device includes: a display section including a display surface extending from a first-end side of a housing to a second-end side of the housing opposite the first-end side; and multiple operation parts arranged from the first-end side to the second-end side of the housing and each including an operation surface. At least a portion of the operation surface of a first operation part, which is arranged on the first-end side, has a height from a placement surface greater than that of at least a portion of the operation surface of a second operation part, which is arranged on the second-end side. The display surface of the display section has a height from the placement surface which is not greater on the first-end side than on the second-end side.

## Description

### FIELD

The present invention relates to an electronic device with a display and a keyboard.

### BACKGROUND

Generally, an electronic device called a calculator is provided with a display and a key input section on the top of its housing. The key input section has multiple keys arranged in a matrix pattern. For example, the key input section has numeric keys, arithmetic keys, function keys, etc., each including multiple keys.

It is normally the case with a small electronic device such as a calculator that multiple keys of the key input section are operated with one hand while processing results according to inputting of keys are presented on the display and visually recognized.

The electronic device is desired to be capable of enabling accurate and quick hitting of keys of the key input section, without easily causing fatigue even from use for a long time.

Conventionally, configurations for mitigating the degree of fatigue have been studied for input devices such as a keyboard furnished with multiple keys as discussed in, for example, Jpn. Pat. Appln. KOKAI Publication No. S62-26717. According to a keyboard device disclosed in this patent application publication, the angle of inclination of the keyboard operation surface can be desirably changed by differentiating its front and back heights with respect to the operator.

### SUMMARY

### TECHNICAL PROBLEM

According to the conventional art as disclosed in Patent Document 1, therefore, the degree of fatigue can be mitigated by providing a configuration in which the angle of inclination of the keyboard operation surface is variable in the front-and-back direction with respect to the operator. Nevertheless, what is considered in this patent application publication is the operability with a keyboard device alone, and it does not assume the viewability of a display for combined use. Even more, Document 1 does not assume one-hand key operation and is silent as to mitigation in the degree of fatigue for cases where keys are operated with one hand.

The present invention has been formulated in view of such problems and its objects include providing an electronic device capable of realizing good key operability while securing a display viewability, so that the user is not easily fatigued.

### SOLUTION TO PROBLEM

To solve the problems, an electronic device according to an embodiment includes: a display section including a display surface extending from a first-end side of a housing to a second-end side of the housing opposite the first-end side; and a plurality of operation parts arranged from the first-end side to the second-end side of the housing and each including an operation surface. At least a portion of the operation surface of a first operation part, which is arranged on the first-end side, has a height from a placement surface greater than that of at least a portion of the operation surface of a second operation part, which is arranged on the second-end side. The display surface of the display section has a height from the placement surface which is not greater on the first-end side than on the second-end side.

### ADVANTAGEOUS EFFECTS OF INVENTION

According to the present invention, it is possible to provide an electronic device capable of realizing good key operability while securing a display viewability, so that the user is not easily fatigued.

### BRIEF DESCRIPTION OF THE DRAWINGS

FIG. 1 is a plan view of an electronic device according to an embodiment.
FIG. 2 is a diagram of the electronic device according to the embodiment, viewed from the lower-side-surface side.
FIG. 3 is a perspective view of the electronic device according to the embodiment.
FIG. 4 is a diagram of the electronic device according to the embodiment, viewed from the right-side-surface side.
FIG. 5 is a diagram showing an exemplary cross-section in the embodiment, taken along the line A-A shown in FIG. 1.
FIG. 6 is a diagram showing a result of measuring an amount of muscle activity of users, with a second housing surface of a key input section according to the embodiment inclined in a row direction of the key arrangement.
FIG. 7 is a diagram showing an exemplary cross-section in the embodiment, taken along the line A-A shown in FIG. 1, in the case where the shapes of the key top upper surfaces are changed.
FIG. 8 is a diagram of the electronic device according to the embodiment with a modified first housing surface of the display section, viewed from the right-side-surface side.
FIG. 9 is a diagram of the electronic device according to the embodiment with a modified first housing surface of the display section, viewed from the lower-side-surface side.

### DETAILED DESCRIPTION

Embodiments of the present invention will be described with reference to the drawings.

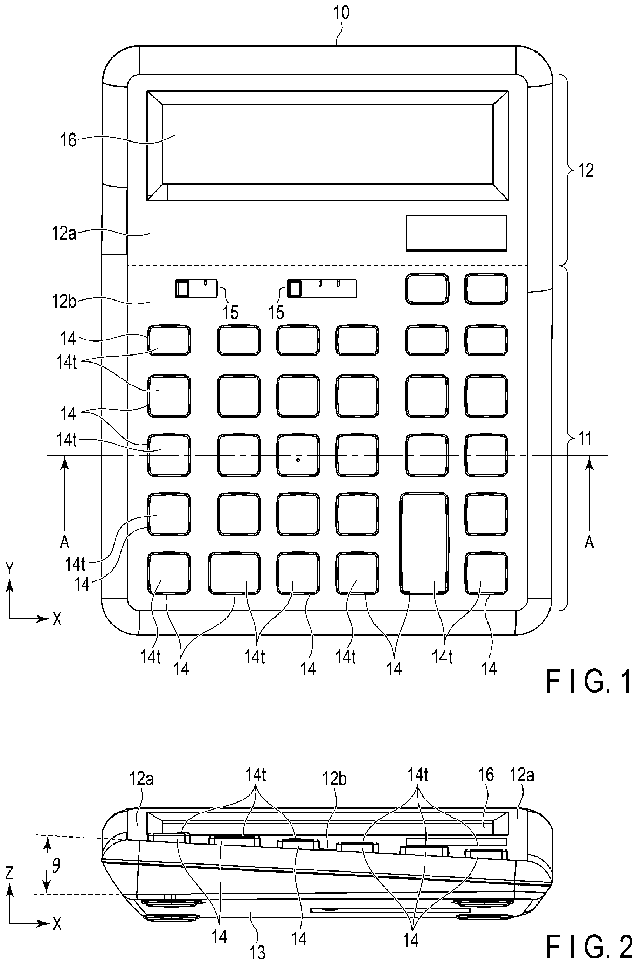

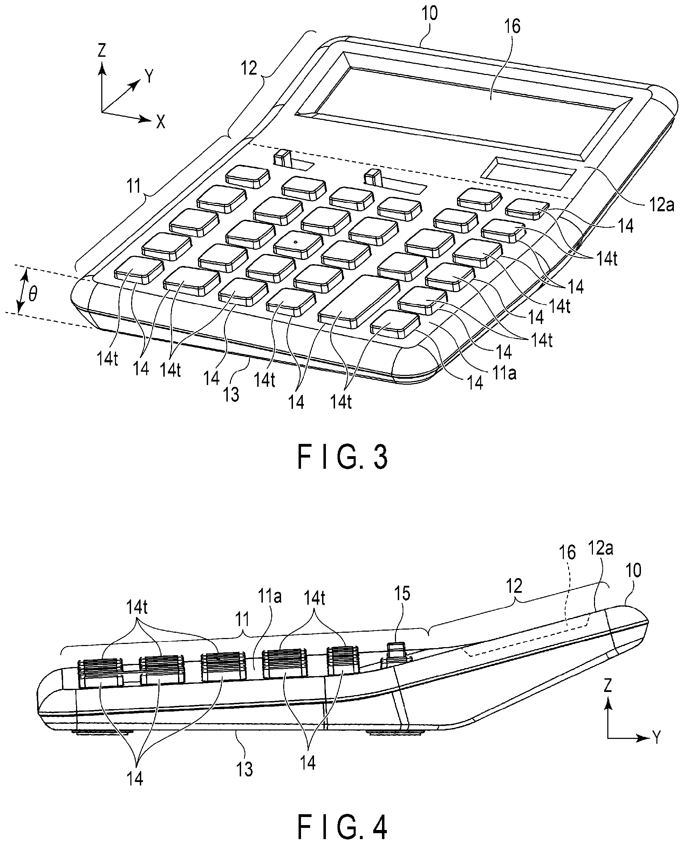

FIGS. 1, 2, 3, and 4 are diagrams showing an external configuration of an electronic device 10 according to an embodiment. FIG. 1 is a plan view of the electronic device 10 according to the embodiment. FIG. 2 is a diagram of the electronic device 10 according to the embodiment, viewed from the lower-side-surface side. FIG. 3 is a perspective view of the electronic device 10 according to the embodiment. FIG. 4 is a diagram of the electronic device 10 according to the embodiment, viewed from the right-side-surface side.

As shown in FIG. 1, the electronic device 10 is provided with a key input section 11 and a display section 12 on the top surface of its housing. The key input section 11 has multiple keys 14, one or more selector switches 15, and so on.

The multiple keys 14 include, for example, numeric keys, arithmetic keys, function keys, etc. The numeric keys include, for example, multiple keys corresponding to [00] and [0] to [9], respectively. The arithmetic keys include, for example, keys for use in normal calculations according to four arithmetic operations, such as keys corresponding to [+] (addition), [-] (subtraction), [×] (multiplication), [÷] (division), and [=] (execution), respectively. The function keys include, for example, an all-clear key (an [AC] key), a clear key (a [C] key), multiple memory keys ([MRC], [M-], and [M+] keys), a root key (a [V] key), and a [%] key.

The selector switch or switches 15 include, for example, a round selector and a decimal point selector.

As shown in FIG. 1, the housing top surface of the electronic device 10 is formed in a substantially rectangular outer shape. The housing top surface includes the display section 12 on an upper side (the upper-edge side of the housing top surface) and the key input section 11 on a lower side (the lower-edge side of the housing top surface).

In the display section 12, a display 16 is disposed on a first housing surface 12a which is a first region (the upper side) of the housing top surface. The display 16 has, for example, a horizontally long rectangular display surface and extends from a first-end side (the left-edge side in FIG. 1) of the housing to a second-end side (the right-edge side in FIG. 1) opposite the first-end side.

In the key input section 11, multiple keys 14 (operation parts) are arranged from the first-end side to the second-end side of the housing and on a second housing surface 11a which is a second region (the lower side) of the housing top surface. The multiple keys 14 each have an operation surface 14t on their respective key tops. The multiple keys 14, in one example, are arranged at predetermined intervals (key pitches) in each of the row and column directions, with the row direction assumed to be a direction parallel to the upper edge/the lower edge of the housing top surface and the column direction assumed to be a direction parallel to the left edge/the right edge of the housing top surface.

In the electronic device 10 according to the embodiment, the second housing surface 11a for the key input section 11 is inclined in a direction from the first-end side to the second-end side, i.e., in the row direction of the arrangement of the multiple keys 14, at a first inclination angle (angle θ) with respect to the placement surface (the bottom surface of the housing). Also, the first housing surface 12a for the display section 12 is substantially in parallel (or substantially horizontal) to the placement surface (the bottom surface of the housing), or is inclined in the direction from the first-end side to the second-end side, i.e., in the row direction of the arrangement of the multiple keys 14, at a second inclination angle different from the first inclination angle (angle θ) with respect to the bottom surface of the housing.

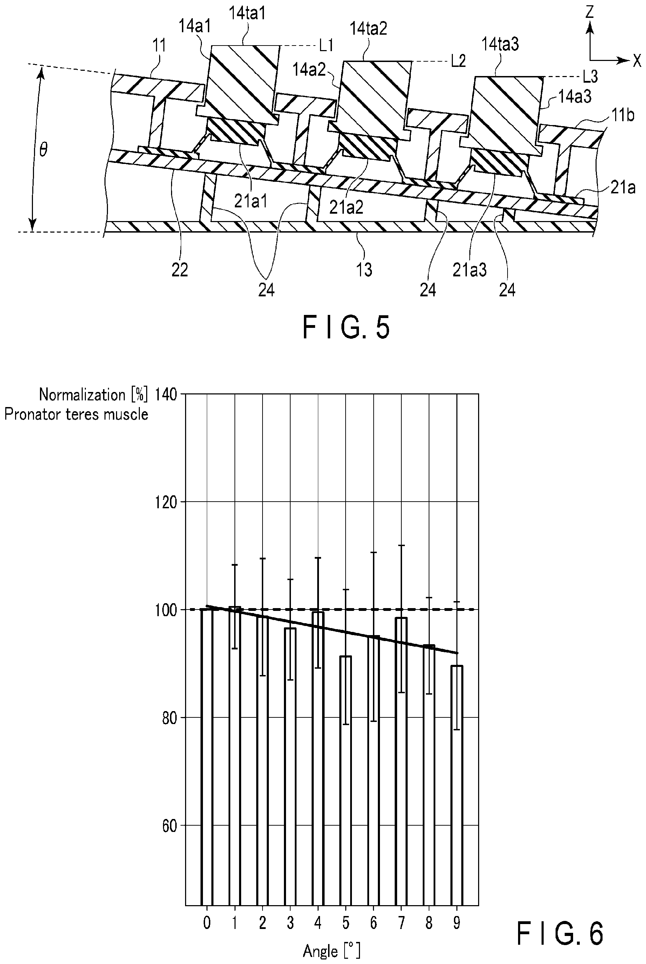

As shown in FIGS. 2 and 4, the second housing surface 11a of the electronic device 10 is formed to be inclined in the row direction, in which the keys 14 are arranged, at the angle θ with respect to the bottom surface 13 of the housing. As an example, it is preferred that the angle θ be in a range of 1° to 9°. It is further preferred that the angle θ be in a range of, for example, 1° to 3° (this will be described in more detail later, referring to FIG. 6).

FIGS. 1 to 4 illustrate a configuration of the electronic device 10 which is an example where the second housing surface 11a of the key input section 11 has a rightward inclination (the left-edge side is higher than the right-edge side) as depicted in FIGS. 2 and 4. In other words, at least a portion of the operation surface 14t of the key 14 (a first operation part) on the first-end side (the left-edge side) is formed to have a greater height from the placement surface (the bottom surface of the housing) than that of at least a portion of the operation surface 14t of the key 14 (a second operation part) on the second-end side (the right-edge side). For example, the central portion (a first central portion) of the operation surface 14t of the key 14 arranged on the first-end side has a greater height from the placement surface (the bottom surface of the housing) than that of the central portion (a second central portion) of the operation surface 14t of the key 14 arranged on the second-end side.

This realizes good operability with the multiple keys 14 and prevents the user from being easily fatigued in the instances where the user operates the electronic device 10 with the right hand (the user is a right-handed user).

Note that, assuming that the user operates the electronic device 10 with the left hand (the user is a left-handed user), it is also possible to adopt a configuration in which the second housing surface 11a of the key input section 11 has a leftward inclination. In other words, at least a portion of the operation surface 14t of the key 14 on the second-end side (the right-edge side) is formed to have a greater height from the placement surface (the bottom surface of the housing) than that of at least a portion of the operation surface 14t of the key 14 on the second-end side (the left-edge side).

On the other hand, the display surface of the display section 12 is formed such that its portion on the first-end side has a height from the placement surface (the bottom surface of the housing) not greater than that of its portion on the second-end side. In the example shown in FIGS. 2 and 4, the first-end portion (the left-edge portion) and the second-end portion (the right-edge portion) of the display section 12 are aligned at the same height, and the upper-edge side of the housing top surface is raised from the boundary between the key input section 11 and the display section 12, so that the inclination in the column direction (the front-and-back direction) of the arrangement of the multiple keys 14 is formed.

As shown in FIG. 4, the housing of the electronic device 10 is bent at the boundary between the key input section 11 and the display section 12 so that the upper-edge side of the housing top surface is positioned higher. Accordingly, the first housing surface 12a for the display section 12 is inclined in the column direction in which the multiple keys 14 are arranged, thereby enhancing viewability of the display surface of the display 16.

FIG. 5 is a diagram showing an exemplary cross-section taken along the line A-A shown in FIG. 1.

As shown in FIG. 5, in the housing of the electronic device 10, a substrate 22 is provided in a state parallel to the second housing surface 11a of the key input section 11. The substrate 22 is supported by multiple support members 24 formed from the bottom portion 13. The substrate 22 supports, inside the housing, the multiple keys 14.

The keys 14 are constituted by, for example, a rubber key 21a and key tops 14a1, 14a2, and 14a3. The rubber key 21a is placed on the upper surface of the substrate 22. The rubber key 21a includes rubber key tops 21a1, 21a2, and 21a3 formed at positions corresponding to the respective key tops 14a1, 14a2, and 14a3 of the multiple keys 14. To the rubber key tops 21a1, 21a2, and 21a3, the respectively corresponding key tops 14a1, 14a2, and 14a3 are attached so that their key stroke directions are made perpendicular to the second housing surface 11a.

The second housing surface 11a has openings corresponding to the multiple keys 14. The openings are each formed in such a manner that the opening wall surface is substantially perpendicular to the substrate 22 and that the opening wall surface and the second housing surface 11a form a substantially right angle. The key tops 14a1, 14a2, and 14a3 pass through the corresponding openings, and their respective operation surfaces 14ta1, 14ta2, and 14ta3 are supported at levels higher than the second housing surface 11a. As such, the side surfaces of the key tops 14a1, 14a2, and 14a3 each face the opening wall surface of the corresponding opening with a slight clearance therebetween so that a substantially parallel movement is permitted.

The rubber key tops 21a1, 21a2, and 21a3 are supported so that they are normally separated from the substrate 24 but are pressed downward until they contact the substrate 24 at the time of a depressing action, in order to provide a feel of a click in response to a depressing action on the key tops 14a1, 14a2, and 14a3 attached on the respective rubber key tops 21a1, 21a2, and 21a3. The rubber key tops 21a1, 21a2, and 21a3 are each provided with a conductive member at their bottom portions so that the rubber key tops 21a1, 21a2, and 21a3 pressed downward by the depressing action on the key tops 14a1, 14a2, and 14a3 will cause the conductive members to contact electrodes arranged on the substrate 22 for the detection of key depression events.

As shown in FIG. 5, the operation surfaces 14ta1, 14ta2, and 14ta3 (upper surfaces) of the key tops 14a1, 14a2, and 14a3 are each formed to be in parallel to the bottom surface 13. In other words, in instances where the electronic device 10 is placed in a horizontal site, the operation surfaces 14ta1, 14ta2, and 14ta3 of the key tops 14a1, 14a2, and 14a3 are horizontal. Heights L1, L2, and L3 of the respective key tops 14a1, 14a2, and 14a3 decrease in order from the key top 14a1 on the first-end side to the key top 14a2 and the key top 14a3 in the direction of the second-end side.

The key tops 14a1, 14a2, and 14a3 are formed in an analogous shape with a comparable stroke length defined by the movable ranges of the rubber key tops 21a1, 21a2, and 21a3, and therefore, the heights L1, L2, and L3 from the bottom surface 13 show a stepped profile according to the inclination angle θ of the second housing surface 11a as shown in FIGS. 2 and 3.

In the electronic device 1 according to the embodiment as shown in FIGS. 2 and 4, the second housing surface 11a of the key input section 11 is inclined in the row direction of the keys 14 at the angle θ with respect to the bottom surface 13, and the operation surface 14t of the key 14 disposed on the first-end side is higher than the operation surface 14t of the key 14 disposed on the second-end side. This realizes good operability with the keys 14 and prevents the user from being easily fatigued.

FIG. 6 is a diagram showing a result of measuring an amount of muscle activity of users, with the second housing surface 11a of the key input section 11 inclined in the row direction of the key arrangement. For FIG. 6, a pronator teres muscle was targeted and what is shown is a result of collecting values measured by an electromyograph during key operations with the electromyograph attached to a position of the pronator teres muscle of an arm.

The measurement was conducted while changing the inclination angle of the second housing surface 11a of the key input section 11 by 1° in the range from 0° to 9°, and FIG. 6 shows an average of measured values from multiple subjects for each angle. Also, in order to indicate a relationship between the measured values (the amounts of muscle activity) at the respective angles, FIG. 6 assumes that the measured value at the angle θ being 0° is 100% and normalizes the measured values at the other angles 1° to 9°.

As shown in FIG. 6, it was found that the amount of muscle activity of the users in the key operations decreases as the angle θ increases. In other words, it was demonstrated that with the second housing surface 11a of the key input section 11 inclined in the row direction of the key arrangement, the users are less likely to be fatigued than in the case where the second housing surface 11a is not inclined in the row direction of the key arrangement.

Additionally, orientations of the palms of the subjects during the key operations were measured. As a result, it was confirmed that in almost all the subjects, the palm was inclined to the right with respect to the horizontal plane (in the case where the keys were operated with the right hand). More concretely, the palms were tilted to the right at an angle ranging from about 5° to 13°.

Therefore, with the second housing surface 11a of the key input section 11 inclined in the row direction of the arrangement of the keys 14, i.e., inclined to the right, the palm of the hand and the second housing surface 11a during the user's key operation can face each other without a large difference in inclination, and accordingly, the operability with the keys 14 can be improved.

Note that, while the amount of muscle activity of the user in key operations decreases as the angle θ increases as shown in FIG. 6, an increase in the angle θ may cause a sense of discomfort in users who are accustomed to key operations with an existing electronic device (calculator) in which multiple keys are not inclined to the right. Thus, it is preferable to set the angle θ in the range of 1° to 3° so that the key operability is improved and the fatigue is reduced without making the user feel uncomfortable.

In the electronic device 10 according to the embodiment, the key input section 11 is inclined to the right, and together, the key top upper surfaces of the keys 14 are each formed horizontally. Therefore, for users who are accustomed to key operations with an existing electronic device (calculator) in which key top upper surfaces are formed horizontally, key operations can be performed without a sense of discomfort.

Although FIG. 5 shows a configuration in which the upper surfaces of the key tops 14a1, 14a2, and 14a3 are formed horizontally (in parallel to the bottom surface 13), these key top upper surfaces may be formed into other shapes.

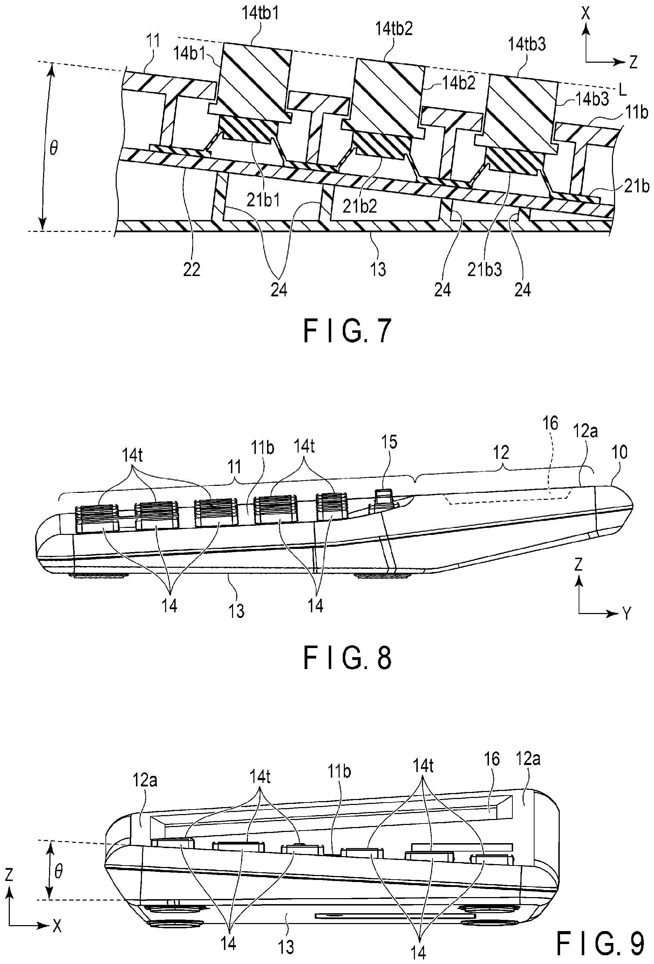

FIG. 7 is a diagram showing an exemplary cross-section taken along the line A-A shown in FIG. 1 in the case where the shapes of the key top upper surfaces are changed. FIG. 7 assumes the same configuration as that shown in FIG. 5 except the operation parts, and thus, a detailed description of the overlapping configuration will be omitted.

In the example shown in FIG. 7, the key tops 14b1, 14b2, and 14b3 are attached to the respectively corresponding rubber key tops 21b1, 21b2, and 21b3 of the rubber key 21b formed in a similar manner to the rubber key 21a shown in FIG. 5, so that their key stroke directions are made perpendicular to the second housing surface 11a.

As shown in FIG. 7, the operation surfaces 14tb1, 14tb2, and 14tb3 (upper surfaces) of the key tops 14b1, 14b2, and 14b3 are each formed to be in parallel to the second housing surface 11a of the key input section 11. In other words, the second housing surface 11a of the key input section 11 and the upper surfaces of all the key tops 14b1, 14b2, and 14b3 are in parallel to each other, and all the key tops 14b1, 14b2, and 14b3 have the same height L from the second housing surface 11a.

Therefore, with the configuration shown in FIG. 7, users who are accustomed to key operations with an existing electronic device (calculator) in which key top operation surfaces (upper surfaces) are formed in parallel to the second housing surface 11a of the key input section 11 can perform key operations without a sense of discomfort.

It is often the case that the electronic device 10 used with the right hand for key operations is placed on the right hand side for use, rather than in front of the user. In the electronic device 10 according to the present embodiment, the second housing surface 11a of the key input section 11 is inclined to the right to improve the operability, etc., and the first housing surface 12a of the display section 12 is inclined in the column direction of the key arrangement to secure the viewability of the display 16 instead of being inclined to the right in conformity with the second housing surface 11a.

Therefore, the electronic device 10 according to the embodiment can realize good operability with the keys 14 and secure viewability of the display 16, so that the user is not easily fatigued.

While FIGS. 1 to 4 have assumed configurations for improving the viewability of the display surface of the display 16 by inclining the first housing surface 12a of the display section 12 in such a manner that the upper-edge side of the housing top surface is raised, it is also possible to adopt a configuration in which the first housing surface 12a has another inclining state as shown in FIG. 8 or FIG. 9.

FIG. 8 is a diagram of the electronic device 10 according to the embodiment with a modified first housing surface 12a of the display section 12, viewed from the right-side-surface side. In the configurations shown in FIGS. 1 to 4, the display section 12 is formed such that the upper-edge side of the housing top surface is raised from the boundary between the key input section 11 and the display section 12 so as to incline the display surface of the display 16. In contrast, in the configuration shown in FIG. 8, the display surface of the display 16 is formed to be substantially horizontal (substantially in parallel to the bottom surface of the housing).

In the example shown in FIG. 8, the left edge/the right edge of the housing top surface for the key input section 11 is formed to be in parallel to the first housing surface 12a of the display section 12.

In other words, the display surface of the display 16 provided in the display section 12 is formed so as to be substantially horizontal (substantially in parallel to the bottom surface of the housing), thereby improving the viewability of the electronic device 10 from above. For example, supposing that the user uses the electronic device 10 by placing it near the body of the user, the viewability of the display 16 from above the electronic device 10 can be improved while the operability is also improved by the rightward inclination of the second housing surface 11a of the key input section 11.

FIG. 9 is a diagram of the electronic device 10 according to the embodiment with a modified first housing surface 12a of the display section 12, viewed from the right-side-surface side.

In the example shown in FIG. 9, the first housing surface 12a of the display section 12 is inclined in the direction opposite the direction in which the second housing surface 11a of the key input section 11 is inclined. In other words, the second housing surface 11a of the key input section 11 is inclined to the right in the row direction of the multiple keys 14, and the first housing surface 12a of the display section 12 is inclined to the left in the row direction of the multiple keys 14.

That is, in the instances where the user performs key operations with the right hand, the device being used is in many cases placed on the right hand side, rather than in front of the user. Thus, the electronic device 10 according to the embodiment adopts the configuration in which, while the second housing surface 11a of the key input section 11 is inclined to the right to improve the operability, the first housing surface 12a of the display section 12 is inclined to the left contrary to the inclination of the second housing surface 11a. This realizes an even more enhanced viewability of the display 16 than in the configuration of only inclining the first housing surface 12a in the column direction (the front-and-back direction) of the arrangement of keys 14 as shown in FIG. 2.

Moreover, the viewability of the display 16 may be enhanced by not only inclining the first housing surface 12a of the display section 12 to the left but also forming the first housing surface 12a such that its portion on the upper-edge side of the housing top surface is at a higher level.

As described above, the electronic device 10 according to the embodiment can realize good operability with the keys 14 while securing viewability of the display 16, so that it is possible to prevent the user from being easily fatigued.

Note that if, in the context of the above description, it is supposed that the user operates the electronic device 10 with the left hand (the user is a left-handed user), the second housing surface 11a of the key input section 11 may be formed to have a leftward inclination in the row direction of the arrangement of the multiple keys 14. In addition, a configuration that is laterally reverse to the configuration for a user who uses the electronic device 10 with the right hand (a right-handed user) may be adopted so that the electronic device 10 can be realized with good operability with the keys 14 while securing viewability of the display 16, so as to prevent a left-handed user from being easily fatigued.

The present invention is not limited to the foregoing embodiments. For practical implementation, various modifications may be adopted without departing from its gist. Moreover, the foregoing embodiments involve various aspects, and appropriate combinations of the features disclosed herein shall permit various inventions to be derived. For example, one or more of the features disclosed in the embodiments may be omitted or combined. Provided that such modifications can solve the intended problem and bring the intended effects as discussed above, the modifications should each be deemed an invention.

### INDUSTRIAL APPLICABILITY

According to the present invention, it is possible to provide an electronic device capable of realizing good key operability while securing a display viewability, so that the user is not easily fatigued.

### REFERENCE SIGNS LIST

- 10: Electronic device
- 11: key input section
- 12: Display section
- 13: Bottom surface
- 14: Key
- 16: Display

## Claims

1. An electronic device comprising:
a display section including a display surface extending from a first-end side of a housing to a second-end side of the housing opposite the first-end side; and
a plurality of operation parts arranged from the first-end side to the second-end side of the housing and each including an operation surface,
**characterized in that**
at least a portion of the operation surface of a first operation part, which is arranged on the first-end side, has a height from a placement surface greater than that of at least a portion of the operation surface of a second operation part, which is arranged on the second-end side, and
the display surface of the display section has a height from the placement surface which is not greater on the first-end side than on the second-end side.

2. The electronic device according to claim 1, **characterized in that** a first central portion of the operation surface of the first operation part has a height from the placement surface greater than that of a second central portion of the operation surface of the second operation part.

3. The electronic device according to claim 1 or 2, **characterized in that**
the display section is disposed on a first housing surface which is a first region of a housing top surface, and
the operation parts are disposed on a second housing surface which is a second region of the housing top surface, the second region differing from the first region.

4. The electronic device according to claim 3, **characterized in that**
the second housing surface is inclined in a direction from the first-end side to the second-end side at a first inclination angle with respect to the placement surface, and
the first housing surface is substantially in parallel to the placement surface, or is inclined in said direction at a second inclination angle different from the first inclination angle with respect to the placement surface.

5. The electronic device according to claim 4, **characterized in that** the operation parts are arranged in a matrix pattern on the second housing surface, and said direction conforms to a row direction of the operation parts.

6. The electronic device according to claim 5, **characterized in that** the first housing surface is inclined in a row direction in which the operation parts are arranged and which is opposite said direction of inclination of the second housing surface.

7. The electronic device according to claim 5, **characterized in that** the first housing surface is inclined in a column direction in which the operation parts are arranged.

8. The electronic device according to any one of claims 3 to 6, **characterized in that** the operation surfaces of the operation parts are in parallel to the second housing surface.

9. The electronic device according to any one of claims 3 to 8, **characterized in that** a substrate supporting the operation parts is provided in the housing, the substrate being in parallel to the second housing surface.
